(19) Europäisches Patentamt
European Patent Office
Office européen des brevets

(11) **EP 4 768 959 A1**

(12) **EUROPEAN PATENT APPLICATION**
published in accordance with Art. 153(4) EPC

(43) Date of publication:
**01.07.2026  Bulletin 2026/27**

(21) Application number: **25779432.1**

(22) Date of filing: **20.01.2025**

(51) International Patent Classification (IPC):
*G01R 31/392* (2019.01)   *G01R 31/396* (2019.01)
*G01R 31/3835* (2019.01)   *G01R 19/165* (2006.01)
*G01R 19/00* (2006.01)   *G01R 31/52* (2020.01)
*G08B 21/18* (2006.01)

(52) Cooperative Patent Classification (CPC):
**G01R 19/00; G01R 19/165; G01R 31/3835;**
**G01R 31/392; G01R 31/396; G01R 31/52;**
**G08B 21/18**

(86) International application number:
**PCT/KR2025/001059**

(87) International publication number:
**WO 2025/206554 (02.10.2025 Gazette 2025/40)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **26.03.2024  KR 20240041265**

(71) Applicant: **LG Energy Solution, Ltd.**
**Seoul 07335 (KR)**

(72) Inventor: **KIM, Young Jin**
**Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **BATTERY DIAGNOSIS DEVICE AND OPERATING METHOD THEREOF**

(57) A battery diagnosis device according to an embodiment of this document may include an acquisition unit that acquires time series voltage data of a plurality of battery cells, a conversion unit that converts the time series voltage data into standard score (Z-score) data in units of cell groups, a calculation unit that calculates a cell diagnosis feature value based on the standard score data, and a diagnosis unit that diagnoses an abnormality of the plurality of battery cells based on the calculated cell diagnosis feature value.

FIG.1

Processed by Luminess, 75001 PARIS (FR)

**Description**

## TECHNICAL FIELD

### Cross-reference to Related Applications

This application claims priority from Korean Patent Application No. 10-2024-0041265, filed on March 26, 2024, the disclosures of which are incorporated by reference herein.

### Technical Field

Embodiments disclosed in this document relate to a battery diagnosis device and an operating method thereof.

## BACKGROUND ART

Recently, research and development on secondary batteries have been actively conducted. Here, secondary batteries are batteries that can be charged and discharged, and include both conventional Ni/Cd batteries, Ni/MH batteries, and recent lithium ion batteries. Among secondary batteries, lithium ion batteries have the advantage of having much higher energy density than conventional Ni/Cd batteries, Ni/MH batteries, etc. In addition, lithium ion batteries may be manufactured to be small and lightweight, and thus the lithium ion batteries are used as a power source for mobile devices. Recently, the scope of use of the lithium ion batteries has expanded to include a power source for electric vehicles, and the lithium ion batteries are attracting attention as a next-generation energy storage medium.

In addition, the secondary batteries may generally be used as a battery pack that includes battery modules in each of which a plurality of battery cells are connected in series and/or in parallel. Also, the secondary batteries may be used as a battery rack that include a plurality of battery modules and a rack frame that accommodate these battery modules.

Such battery cells, battery modules, battery packs, or battery racks may be utilized in various devices. For example, batteries may be utilized in mobile devices such as mobile phones, laptop computers, smart phones, and smart pads, but also in fields such as electric vehicles (EVs, HEVs, and PHEVs) and large-capacity power storage devices (ESS).

The state and operation of these batteries may be managed and controlled by a battery management system (BMS). The battery management system may be included together with a battery within a single device.

In addition, the battery management system may manage and control the battery while being separated from a device including the battery. For example, the battery management system may be implemented as a separate server device. In this case, the battery management system may collect battery data and vehicle data from vehicles, etc., and manage and control the battery using the collected data.

## DISCLOSURE OF THE INVENTION

## TECHNICAL PROBLEM

Meanwhile, when a battery is defective, the possibility of damage to devices including the battery (e.g., EV and ESS) may increase. Accordingly, a method of detecting an abnormal state of the battery and reducing the possibility of damage to devices including the battery is required.

The embodiments disclosed in this document can provide a battery diagnosis device capable of calculating a cell diagnosis feature value to be used for diagnosing a battery cell based on standard score data converted from time series voltage data of the battery cell and an operating method thereof.

The technical problems of the embodiments disclosed in this document are not limited to the technical problems mentioned above, and other technical problems that are not mentioned may be clearly understood by those skilled in the art from the descriptions below.

## TECHNICAL SOLUTION

A battery diagnosis device according to an embodiment disclosed in this document may include an acquisition unit that acquires time series voltage data of a plurality of battery cells, a conversion unit that converts the time series voltage data into standard score (Z-score) data in units of cell groups, a calculation unit that calculates a cell diagnosis feature value based on the standard score data, and a diagnosis unit that diagnoses an abnormality of the plurality of battery cells based on the calculated cell diagnosis feature value.

In the battery diagnosis device according to an embodiment disclosed in this document, the acquisition unit may acquire the time series voltage data satisfying a specified condition, and the specified condition may include at least one of a first condition in which a time length of data is greater than or equal to a specified time length or a second condition in which a state of charge (SOC) of a battery cell is greater than or equal to a specified SOC.

In the battery diagnosis device according to an embodiment disclosed in this document, the conversion unit may convert the time series voltage data into the standard score data based on Equation 1 below.

[Equation 1]

$$Z_i = \frac{V_{cells,i} - mean(V_{cellgroup})}{std(V_{cellgroup})}$$

(In Equation 1, $Z_i$ is a standard score of an i-th battery cell among the plurality of battery cells, $V_{cells,i}$ is a voltage of the i-th battery cell, mean $(V_{cell\,group})$ is an average voltage of a cell group including the i-th battery cell, and std $(V_{cell\,group})$ is a voltage standard deviation of battery cells included in the cell group.)

In the battery diagnosis device according to an embodiment disclosed in this document, the calculation unit may calculate a target feature value by cumulatively adding an absolute value of a difference value between a standard score in a current cycle and a standard score in a previous cycle within a specified cycle for each battery cell based on the standard score data, and calculate the cell diagnosis feature value based on the target feature value.

In the battery diagnosis device according to an embodiment disclosed in the present document, the calculation unit may calculate a variance value of a plurality of target feature values corresponding to each of a plurality of cycles as the cell diagnosis feature value.

The battery diagnosis device according to an embodiment disclosed in this document may further include an abnormality processing unit that performs an abnormality processing function based on an abnormality diagnosis result of the plurality of battery cells, and the abnormality processing function may include a notification function or a short-circuit function.

An operating method of a battery diagnosis device according to an embodiment disclosed in this document may include an operation of acquiring time series voltage data of a plurality of battery cells, an operation of converting the time series voltage data into standard score (Z-score) data in units of cell groups, an operation of calculating a cell diagnosis feature value based on the standard score data, and an operation of diagnosing an abnormality of the plurality of battery cells based on the calculated cell diagnosis feature value.

In the operating method of the battery diagnosis device according to an embodiment disclosed in this document, the operation of acquiring the time series voltage data may include an operation of acquiring the time series voltage data satisfying a specified condition, and the specified condition may include at least one of a first condition in which a time length of data is greater than or equal to a specified time length or a second condition in which a state of charge (SOC) of a battery cell is greater than or equal to a specified SOC.

In the operating method of the battery diagnosis device according to an embodiment disclosed in this document, the operation of converting the time series voltage data into the standard score data may be based on Equation 1 above.

In the operating method of the battery diagnosis device according to an embodiment disclosed in this document, the operation of calculating the cell diagnosis feature value may include an operation of calculating a target feature value by cumulatively adding an absolute value of a difference value between a standard score in a current cycle and a standard score in a previous cycle within a specified cycle for each battery cell based on the standard score data, and an operation of calculating the cell diagnosis feature value based on the target feature value.

In the operating method of the battery diagnosis device according to an embodiment disclosed in this document, the operation of calculating the cell diagnosis feature value may include an operation of calculating a variance value of a plurality of target feature values of each of the plurality of battery cells as the cell diagnosis feature value.

The operating method of the battery diagnosis device according to an embodiment disclosed in this document may further include an operation of performing an abnormality processing function based on an abnormality diagnosis result of the plurality of battery cells, and the abnormality processing function may include a notification function or a short-circuit function.

## ADVANTAGEOUS EFFECTS

According to the embodiments disclosed in this document, the diagnosis accuracy can be improved by calculating a diagnosis index using a voltage standard score of the battery cell.

In addition, various effects can be provided that are directly or indirectly identified through this document.

## BRIEF DESCRIPTION OF THE DRAWINGS

FIG. 1 is a block diagram of a battery diagnosis device according to an embodiment.
FIG. 2 is an operation flow diagram of a battery diagnosis device according to an embodiment.
FIG. 3 is an operation flow diagram of a battery diagnosis device according to an embodiment.
FIG. 4 is a block diagram illustrating a hardware configuration of a computing system for performing an operating method of a battery diagnosis device according to an embodiment.

## MODE FOR CARRYING OUT THE INVENTION

Hereinafter, various embodiments of the present invention are described with reference to the accompanying drawings. However, this is not intended to limit the present invention to specific embodiments, and it should be understood that various modifications, equivalents, and/or alternatives of the embodiments of the present invention are included.

Various embodiments of this document and the terms used therein are not intended to limit the technical features described in this document to specific embodiments, but should be understood to include various modifications, equivalents, or alternatives of the embodiment. In connection with the description of the drawings, similar reference numerals may be used for similar or related components. The singular form of a noun corresponding to an item may include one or more of said items, unless the context clearly indicates otherwise.

In this document, each of phrases "A or B", "at least one of A and B", "at least one of A or B", "A, B, or C", "at least one of A, B, and C", and "at least one of A, B, or C" may include any one of the items listed together in that phrase, or all possible combinations thereof. Terms such as "first", "second", "firstly", "secondly", "A", "B", "(a)", or "(b)" may be used merely to distinguish one component from another, and do not limit the components in any other respect (e.g., importance or order) unless specifically stated otherwise.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by being added with one or more other operations.

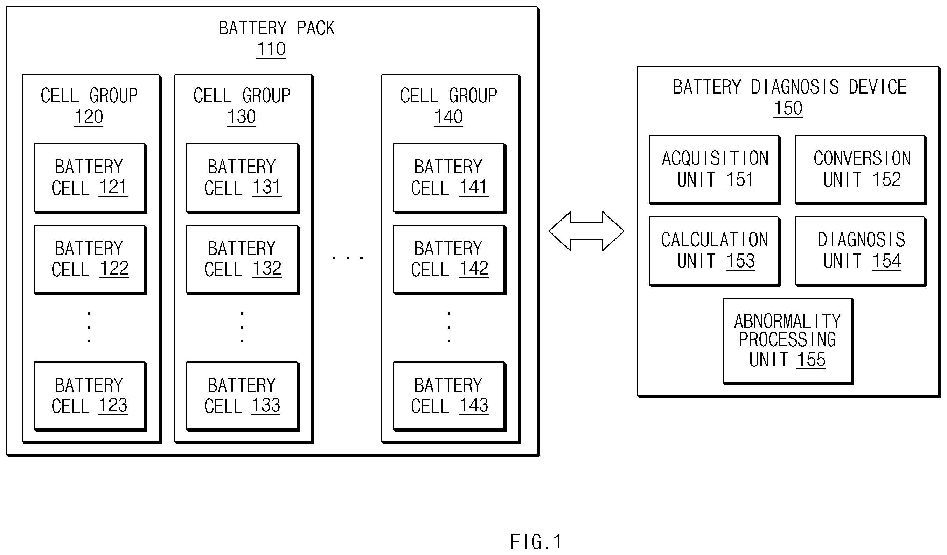

FIG. 1 is a block diagram of a battery diagnosis device according to an embodiment.

Referring to FIG. 1, a battery pack 110 includes a plurality of cell groups 120, 130, and 140, and each of the plurality of cell groups 120, 130, and 140 may include a plurality of battery cells 121, 122, 123, 131, 132, 133, 141, 142, and 143. According to an embodiment, the battery pack 110 may be a battery mounted inside an electric vehicle to provide power to the electric vehicle.

According to an embodiment, a battery diagnosis device 150 may diagnose an abnormality of a battery unit based on time series voltage data acquired from the battery unit. In the present disclosure, the battery unit may refer to the battery pack 110, the cell group 120, 130, or 140, or the battery cell 121, 122, 123, 131, 132, 133, 141, 142, or 143.

According to an embodiment, the battery diagnosis device 150 may be formed integrally with the battery unit. In this case, the battery diagnosis device 150 may be implemented as a battery management system (BMS) of the battery unit.

According to an embodiment, the battery diagnosis device 150 may be formed separately from the battery unit. In this case, the battery diagnosis device 150 may be implemented as an external server (e.g., a cloud) connected to the battery unit through a wireless network.

According to an embodiment, the battery diagnosis device 150 may include an acquisition unit 151, a conversion unit 152, a calculation unit 153, a diagnosis unit 154, and/or an abnormality processing unit 155. According to an embodiment, the battery diagnosis device 150 illustrated in FIG. 1 may further include at least one component other than the components illustrated in FIG. 1, or may omit at least one component (e.g., an abnormality processing unit 155) among the components illustrated in FIG. 1.

According to an embodiment, the acquisition unit 151 may acquire time series voltage data of a plurality of battery cells 121, 122, 123, 131, 132, 133, 141, 142, and 143 included in the battery pack 110. Here, the time series voltage data may be data representing the voltage of the plurality of battery cells 121, 122, 123, 131, 132, 133, 141, 142, and 143 over time.

For example, when the battery diagnosis device 150 is implemented as the BMS of the battery unit, the acquisition unit 151 may measure the voltage of the plurality of battery cells 121, 122, 123, 131, 132, 133, 141, 142, and 143 to acquire time series voltage data. In this case, the acquisition unit 151 may use a sensor for measuring the battery voltage.

As another example, when the battery diagnosis device 150 is implemented as an external server, the acquisition unit 151 may receive the time series voltage data of the plurality of battery cells 121, 122, 123, 131, 132, 133, 141, 142, 143 acquired by the battery unit. In this case, the acquisition unit 151 may use a communication circuit capable of wired and/or wireless network communication.

According to an embodiment, the acquisition unit 151 may acquire time series voltage data that satisfies a specified condition. Here, the specified condition may include at least one of a first condition in which a time length of data is greater than or equal to a specified time length, or a second condition in which a state of charge (SOC) of the battery cells 121, 122, 123, 131, 132, 133, 141, 142, and/or 143 is greater than or equal to a specified SOC.

According to an embodiment, the conversion unit 152 may convert the time series voltage data acquired by the acquisition unit 151 into standard score (Z-score) data in units of cell groups. Here, converting the time series voltage data in units of cell groups may refer to converting time series voltage data of each battery cell into standard score data using time series voltage data of all battery cells included in a specific cell group 120, 130, or 140. For example, the conversion unit 152 may convert the time series voltage data of the battery cells 121, 122, and 123 included in the cell group 120 into standard score data by using the time series voltage data of the battery cells 121, 122, and 123.

According to an embodiment, the conversion unit 152 may convert the time series voltage data of the plurality of battery cells 121, 122, 123, 131, 132, 133, 141, 142, and 143 into standard score data based on Equation 1 below.

[Equation 1]

$$Z_i = \frac{V_{cells,i} - mean(V_{cellgroup})}{std(V_{cellgroup})}$$

In Equation 1 above, $Z_i$ is a standard score of an i-th battery cell (e.g., 121) among a plurality of battery cells 121, 122, 123, 131, 132, 133, 141, 142, and 143, $V_{cells,i}$ is a voltage of the i-th battery cell, mean ($V_{cellgroup}$) is an average voltage of a cell group (e.g., 120) including the i-th battery cell, and std($V_{cellgroup}$) is a voltage standard deviation of battery cells (e.g., 121, 122, and 123) included in the cell group.

According to an embodiment, the calculation unit 153 may calculate a cell diagnosis feature value based on the standard score data converted by the conversion unit 152.

According to an embodiment, the calculation unit 153 may calculate the cell diagnosis feature value corresponding to each of the plurality of battery cells 121, 122, 123, 131, 132, 133, 141, 142, and 143. Hereinafter, for convenience of description, only an example, in which the calculation unit 153 calculates the cell diagnosis feature value corresponding to the first battery cell 121 which is a battery cell to be diagnosed among the plurality of battery cells 121, 122, 123, 131, 132, 133, 141, 142, and 143, will be described.

According to an embodiment, the calculation unit 153 may calculate an absolute value of a difference value between a standard score in a current cycle and a standard score in a previous cycle for the first battery cell 121. The calculation unit 153 may calculate a target feature value by cumulatively adding up the calculated absolute values within a specified cycle (e.g., a charge/discharge cycle). Here, the target feature value may correspond to the specific charge/-discharge cycle.

According to an embodiment, the calculation unit 153 may calculate, for the first battery cell 121, a variance value of the plurality of target feature values corresponding to each of the plurality of cycles as a cell diagnosis feature value corresponding to the first battery cell 121.

The cell diagnosis feature value calculation method described above may be equally applied when calculating the cell diagnosis feature value corresponding to each of the plurality of battery cells 121, 122, 123, 131, 132, 133, 141, 142, and 143 included in the battery pack 110 as well as the first battery cell 121.

According to an embodiment, the diagnosis unit 154 may diagnose an abnormality of the plurality of battery cells 121, 122, 123, 131, 132, 133, 141, 142, and 143 based on the cell diagnosis feature value calculated by the calculation unit 153.

According to an embodiment, the diagnosis unit 154 may diagnose an abnormality of a battery cell to be diagnosed based on a cell diagnosis feature value corresponding to the battery cell to be diagnosed among the plurality of battery cells 121, 122, 123, 131, 132, 133, 141, 142, and 143. For example, the diagnosis unit 154 may diagnose the abnormality of the first battery cell 121 based on the cell diagnosis feature value corresponding to the first battery cell 121, which is a battery cell to be diagnosed.

According to an embodiment, the diagnosis unit 154 may diagnose the abnormality of the plurality of battery cells 121, 122, 123, 131, 132, 133, 141, 142, and 143 by comparing the cell diagnosis feature values corresponding to the plurality of battery cells 121, 122, 123, 131, 132, 133, 141, 142, and 143 with a preset threshold feature value.

According to an embodiment, the abnormality processing unit 155 may perform an abnormality processing function based on abnormality diagnosis results of the plurality of battery cells 121, 122, 123, 131, 132, 133, 141, 142, and 143. Here, the abnormality processing function may include a notification function or a short-circuit function.

According to an embodiment of the present invention, the abnormality processing unit 155 may transmit the abnormality diagnosis results of the plurality of battery cells 121, 122, 123, 131, 132, 133, 141, and 143 to a user terminal connected through a wired and/or wireless network.

According to an embodiment, the abnormality processing unit 155 may isolate an abnormal battery cell from an electronic device in which the plurality of battery cells 121, 122, 123, 131, 132, 133, 141, 142, and 143 are placed based on the abnormality diagnosis results of the plurality of battery cells 121, 122, 123, 131, 132, 133, 141, 142, and 143. Here, the isolation may include electrical and/or mechanical isolation.

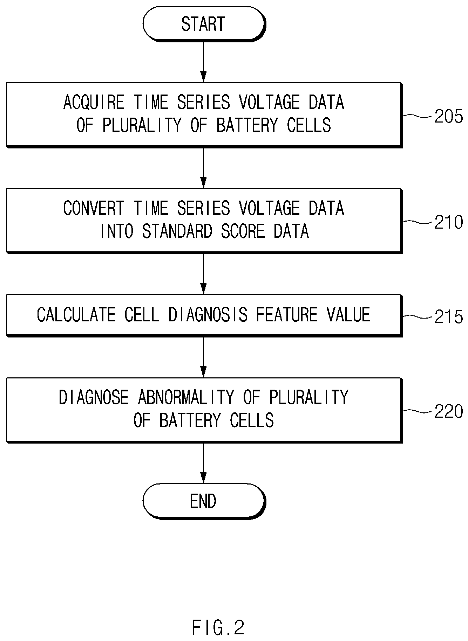

FIG. 2 is an operation flowchart of the battery diagnosis device according to an embodiment. FIG. 2 may be described using the configurations of FIG. 1.

The embodiment illustrated in FIG. 2 is only an embodiment, and the order of steps according to various embodiments of the present invention may be different from that illustrated in FIG. 2, and some steps illustrated in FIG. 2 may be omitted, the order between steps may be changed, or steps may be merged.

Referring to FIG. 2, in operation 205, the battery diagnosis device 150 may acquire time series voltage data of the plurality of battery cells 121, 122, 123, 131, 132, 133, 141, 142, and 143 included in the battery pack 110. Here, the time series voltage data may be data representing voltages of the plurality of battery cells 121, 122, 123, 131, 132, 133, 141, 142, and 143 over time.

According to an embodiment, the battery diagnosis device 150 may acquire the time series voltage data satisfying a specified condition. Here, the specified condition may include at least one of a first condition in which a time length of data is greater than or equal to a specified time length or a second condition in which a state of charge (SOC) of the battery cells 121, 122, 123, 131, 132, 133, 141, 142, and/or 143 is greater than or equal to a specified SOC.

In operation 210, the battery diagnosis device 150 may convert the time series voltage data acquired in operation 205 into standard score data in units of cell groups. According to an embodiment, the battery diagnosis device 150 may convert the time series voltage data of the plurality of battery cells 121, 122, 123, 131, 132, 133, 141, 142, and 143 into the standard score data based on Equation 1 described above.

In operation 215, the battery diagnosis device 150 may calculate a cell diagnosis feature value based on the standard score data converted in operation 210.

According to an embodiment, the battery diagnosis device 150 may calculate the cell diagnosis feature value corresponding to each of the plurality of battery cells 121, 122, 123, 131, 132, 133, 141, 142, and 143.

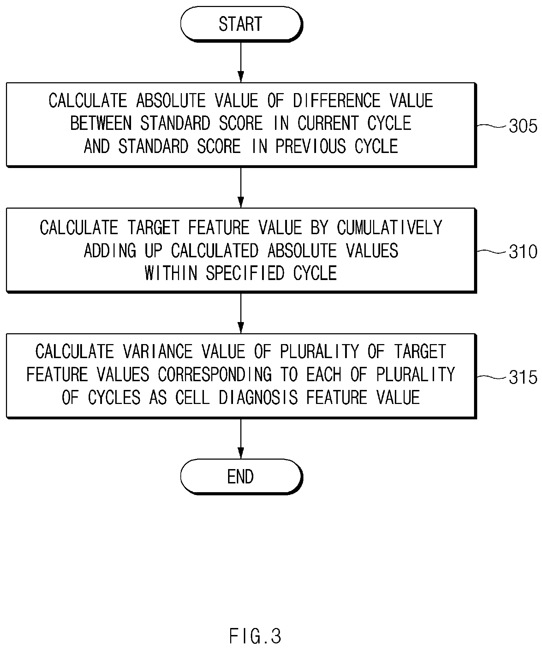

Operation 215, in which the battery diagnosis device 150 calculates the cell diagnosis feature value, may be described in more detail with reference to FIG. 3, which will be described below.

In operation 220, the battery diagnosis device 150 may diagnose an abnormality of the plurality of battery cells 121, 122, 123, 131, 132, 133, 141, 142, and 143 based on the cell diagnosis feature value calculated in operation 215.

According to an embodiment, the battery diagnosis device 150 may diagnose the abnormality of a battery cell to be diagnosed based on the cell diagnosis feature value corresponding to the battery cell to be diagnosed among the plurality of battery cells 121, 122, 123, 131, 132, 133, 141, 142, and 143. For example, the battery diagnosis device 150 may diagnose the abnormality of the first battery cell 121 based on the cell diagnosis feature value corresponding to the first battery cell 121, which is a battery cell to be diagnosed.

According to an embodiment, the battery diagnosis device 150 may diagnose the abnormality of the plurality of battery cells 121, 122, 123, 131, 132, 133, 141, 142, and 143 by comparing the cell diagnosis feature values corresponding to the plurality of battery cells 121, 122, 123, 131, 132, 133, 141, 142, and 143 with a preset threshold feature value.

According to an embodiment, the battery diagnosis device 150 may perform an abnormality processing function based on abnormality diagnosis results of the plurality of battery cells 121, 122, 123, 131, 132, 133, 141, 142, and 143. Here, the abnormality processing function may include a notification function or a short-circuit function.

According to an embodiment, the battery diagnosis device 150 may transmit the abnormality diagnosis results of the plurality of battery cells 121, 122, 123, 131, 132, 133, 141, 142, and 143 to a user terminal connected through a wired and/or wireless network.

According to an embodiment, the battery diagnosis device 150 may isolate an abnormal battery cell from an electronic device in which the plurality of battery cells 121, 122, 123, 131, 132, 133, 141, 142, and 143 are placed based on the abnormality diagnosis results of the plurality of battery cells 121, 122, 123, 131, 132, 133, 141, 142, and 143. Here, the isolation may include electrical and/or mechanical isolation.

Hereinafter, a method for calculating a cell diagnosis feature value by the battery diagnosis device 150 will be described through FIG. 3.

FIG. 3 is an operation flowchart of the battery diagnosis device according to an embodiment. FIG. 3 may be described using the configurations of FIG. 1.

The embodiment illustrated in FIG. 3 is only an embodiment, and the order of steps according to various embodiments of the present invention may be different from that illustrated in FIG. 3, and some steps illustrated in FIG. 3 may be omitted, the order between steps may be changed, or steps may be merged.

Referring to FIG. 3, in operation 305, the battery diagnosis device 150 may calculate an absolute value of a difference value between a standard score in a current cycle and a standard score in a previous cycle for the first battery cell 121 based on standard score data.

In operation 310, the battery diagnosis device 150 may calculate a target feature value by cumulatively adding up the calculated absolute values within a specified cycle (e.g., a charge/discharge cycle). Here, the target feature value may correspond to a specific charge/discharge cycle.

In operation 315, the battery diagnosis device 150 may calculate a variance value of a plurality of target feature values corresponding to each of a plurality of cycles as a cell diagnosis feature value.

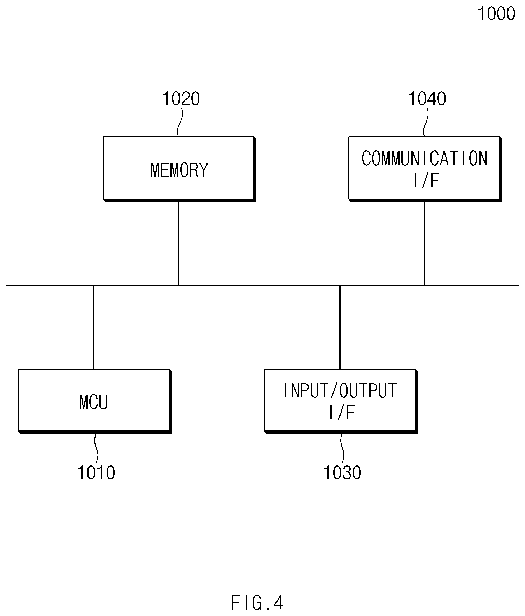

FIG. 4 is a block diagram illustrating a hardware configuration of a computing system for performing an operating method of a battery diagnosis device according to an embodiment.

Referring to FIG. 4, a computing system 1000 according to an embodiment disclosed in this document may include an MCU 1010, a memory 1020, an input/output I/F 1030, and a communication I/F 1040.

The MCU 1010 may be a processor that executes various programs (e.g., battery cell voltage collection programs, data conversion programs, cell diagnosis feature value calculation programs, cell diagnosis programs, etc.) stored in the memory 1020, processes various information including the cell voltage, the standard score data, and the cell diagnosis feature value through these programs, and performs functions by the configurations of the battery diagnosis device illustrated in FIG. 1 described above.

The memory 1020 may store various programs such as the battery cell voltage collection programs, the data conversion programs, the cell diagnosis feature value calculation programs, the cell diagnosis programs, etc. In addition, the memory 1020 may store various information such as time series voltage data of the battery cell.

A plurality of such memories 1020 may be provided as needed. The memory 1020 may be a volatile memory or a nonvolatile memory. As the memory 220 as the volatile memory, RAM, DRAM, SRAM, etc. may be used. As the memory 220 as the non-volatile memory, ROM, PROM, EAROM, EPROM, EEPROM, flash memory, etc. may be used. The examples of the memories 1020 listed above are only examples and the memories 1020 are not limited to these examples.

As the input/output I/F 1030, there may be provided an interface that connects an input device (not illustrated) such as a keyboard, mouse, or touch panel, an output device such as a display (not illustrated), and the MCU 1010 to allow data to be transmitted and received therebetween.

The communication I/F 1040 may be a configuration that can transmit and receive various data with a server, and may be various devices that can support wired or wireless communication. For example, the battery diagnosis device can transmit and receive information such as time series voltage data of battery cell and battery cell abnormality diagnosis results to and from a separately provided external server through the communication I/F 1040.

In this way, the computer program according to an embodiment disclosed in this document may be implemented as a module that performs each of the functions illustrated in FIG. 1 by being recorded in the memory 1020 and processed by the MCU 1010, for example.

The terms "include," "configure," or "have" described above, unless specifically stated to the contrary, mean that the corresponding component may be included therein, and therefore should be interpreted as further including other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

**Claims**

1. A battery diagnosis device comprising:

   an acquisition unit that acquires time series voltage data of a plurality of battery cells;
   a conversion unit that converts the time series voltage data into standard score (Z-score) data in units of cell groups;

a calculation unit that calculates a cell diagnosis feature value based on the standard score data; and
a diagnosis unit that diagnoses an abnormality of the plurality of battery cells based on the calculated cell diagnosis feature value.

2. The battery diagnosis device of claim 1, wherein the acquisition unit acquires the time series voltage data satisfying a specified condition, and
the specified condition includes at least one of a first condition in which a time length of data is greater than or equal to a specified time length or a second condition in which a state of charge (SOC) of a battery cell is greater than or equal to a specified SOC.

3. The battery diagnosis device of claim 1, wherein the conversion unit converts the time series voltage data into the standard score data based on Equation 1 below,

[Equation 1]

$$Z_i = \frac{V_{cells,i} - mean(V_{cellgroup})}{std(V_{cellgroup})}$$

(in Equation 1, $Z_i$ is a standard score of an i-th battery cell among the plurality of battery cells, $V_{cells,i}$ is a voltage of the i-th battery cell, mean $(V_{cellgroup})$ is an average voltage of a cell group including the i-th battery cell, and std$(V_{cellgroup})$ is a voltage standard deviation of battery cells included in the cell group).

4. The battery diagnosis device of claim 1, wherein the calculation unit calculates a target feature value by cumulatively adding an absolute value of a difference value between a standard score in a current cycle and a standard score in a previous cycle within a specified cycle for each battery cell based on the standard score data, and
calculates the cell diagnosis feature value based on the target feature value.

5. The battery diagnosis device of claim 4, wherein the calculation unit calculates a variance value of a plurality of target feature values corresponding to each of a plurality of cycles as the cell diagnosis feature value.

6. The battery diagnosis device of claim 1, further comprising:

an abnormality processing unit that performs an abnormality processing function based on an abnormality diagnosis result of the plurality of battery cells,
wherein the abnormality processing function includes a notification function or a short-circuit function.

7. An operating method of a battery diagnosis device, the method comprising:

an operation of acquiring time series voltage data of a plurality of battery cells;
an operation of converting the time series voltage data into standard score (Z-score) data in units of cell groups;
an operation of calculating a cell diagnosis feature value based on the standard score data; and
an operation of diagnosing an abnormality of the plurality of battery cells based on the calculated cell diagnosis feature value.

8. The operating method of claim 7, wherein the operation of acquiring the time series voltage data includes an operation of acquiring the time series voltage data satisfying a specified condition, and
the specified condition includes at least one of a first condition in which a time length of data is greater than or equal to a specified time length or a second condition in which a state of charge (SOC) of a battery cell is greater than or equal to a specified SOC.

9. The operating method of claim 7, wherein the operation of converting the time series voltage data into the standard score data is based on Equation 1 below,

[Equation 1]

$$Z_i = \frac{V_{cells,i} - mean(V_{cellgroup})}{std(V_{cellgroup})}$$

(in Equation 1, $Z_i$ is a standard score of an i-th battery cell among the plurality of battery cells, $V_{cells,i}$ is a voltage of the i-th battery cell, mean ($V_{cellgroup}$) is an average voltage of a cell group including the i-th battery cell, and std($V_{cellgroup}$) is a voltage standard deviation of battery cells included in the cell group).

10. The operating method of claim 7, wherein the operation of calculating the cell diagnosis feature value includes:

an operation of calculating a target feature value by cumulatively adding an absolute value of a difference value between a standard score in a current cycle and a standard score in a previous cycle within a specified cycle for each battery cell based on the standard score data; and
an operation of calculating the cell diagnosis feature value based on the target feature value.

11. The operating method of claim 10, wherein the operation of calculating the cell diagnosis feature value includes an operation of calculating a variance value of a plurality of target feature values of each of the plurality of battery cells as the cell diagnosis feature value.

12. The operating method of claim 7, further comprising:

an operation of performing an abnormality processing function based on an abnormality diagnosis result of the plurality of battery cells,
wherein the abnormality processing function includes a notification function or a short-circuit function.

F I G . 1

EP 4 768 959 A1

START

ACQUIRE TIME SERIES VOLTAGE DATA
OF PLURALITY OF BATTERY CELLS ── 205

CONVERT TIME SERIES VOLTAGE DATA
INTO STANDARD SCORE DATA ── 210

CALCULATE CELL DIAGNOSIS FEATURE VALUE ── 215

DIAGNOSE ABNORMALITY OF PLURALITY
OF BATTERY CELLS ── 220

END

FIG.2

START

CALCULATE ABSOLUTE VALUE OF DIFFERENCE VALUE
BETWEEN STANDARD SCORE IN CURRENT CYCLE
AND STANDARD SCORE IN PREVIOUS CYCLE — 305

CALCULATE TARGET FEATURE VALUE BY CUMULATIVELY
ADDING UP CALCULATED ABSOLUTE VALUES
WITHIN SPECIFIED CYCLE — 310

CALCULATE VARIANCE VALUE OF PLURALITY OF TARGET
FEATURE VALUES CORRESPONDING TO EACH OF PLURALITY
OF CYCLES AS CELL DIAGNOSIS FEATURE VALUE — 315

END

FIG.3

1000

1020

1040

MEMORY

COMMUNICATION
I/F

MCU

INPUT/OUTPUT
I/F

1010

1030

FIG.4

## INTERNATIONAL SEARCH REPORT

| International application No. |
|---|
| **PCT/KR2025/001059** |

| | |
|---|---|
| **A.** | **CLASSIFICATION OF SUBJECT MATTER** |
| | **G01R 31/392**(2019.01)i; **G01R 31/396**(2019.01)i; **G01R 31/3835**(2019.01)i; **G01R 19/165**(2006.01)i; **G01R 19/00**(2006.01)i; **G01R 31/52**(2020.01)i; **G08B 21/18**(2006.01)i |
| | According to International Patent Classification (IPC) or to both national classification and IPC |

| | |
|---|---|
| **B.** | **FIELDS SEARCHED** |
| | Minimum documentation searched (classification system followed by classification symbols) |
| | G01R 31/392(2019.01); G01R 19/00(2006.01); G01R 31/50(2020.01); H01M 10/48(2006.01) |
| | Documentation searched other than minimum documentation to the extent that such documents are included in the fields searched |
| | Korean utility models and applications for utility models: IPC as above<br>Japanese utility models and applications for utility models: IPC as above |
| | Electronic data base consulted during the international search (name of data base and, where practicable, search terms used) |
| | eKOMPASS (KIPO internal) & keywords: 배터리(battery), 전압(voltage), 표준 점수(Z-score), 이상 진단(abnormal diagnosis) |

| | |
|---|---|
| **C.** | **DOCUMENTS CONSIDERED TO BE RELEVANT** |

| Category* | Citation of document, with indication, where appropriate, of the relevant passages | Relevant to claim No. |
|---|---|---|
| X<br>Y | KR 10-2023-0069591 A (LG ENERGY SOLUTION, LTD.) 19 May 2023 (2023-05-19)<br>See paragraph [0050], claim 1 and figures 1-2. | 1-3,7-9<br>4-6,10-12 |
| Y | KR 10-2022-0001364 A (LG ENERGY SOLUTION, LTD.) 05 January 2022 (2022-01-05)<br>See paragraphs [0074]-[0087] and figures 5-6. | 4-6,10-12 |
| A | KR 10-2022-0032471 A (HYUNDAI MOTOR COMPANY et al.) 15 March 2022 (2022-03-15)<br>See claim 18 and figure 10. | 1-12 |
| A | KR 10-2021-0059566 A (SAMSUNG SDI CO,. LTD.) 25 May 2021 (2021-05-25)<br>See claim 1 and figure 4. | 1-12 |
| A | KR 10-2023-0088014 A (LG ENERGY SOLUTION, LTD.) 19 June 2023 (2023-06-19)<br>See claim 1 and figure 1. | 1-12 |

| | | | |
|---|---|---|---|
| ☐ Further documents are listed in the continuation of Box C. | | ☑ See patent family annex. | |

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **21 April 2025** | **21 April 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2025/001059**

| Patent document cited in search report | | | Publication date (day/month/year) | Patent family member(s) | | | Publication date (day/month/year) |
|---|---|---|---|---|---|---|---|
| KR | 10-2023-0069591 | A | 19 May 2023 | None | | | |
| KR | 10-2022-0001364 | A | 05 January 2022 | KR | 10-2782821 | B1 | 14 March 2025 |
| KR | 10-2022-0032471 | A | 15 March 2022 | CN | 114156546 | A | 08 March 2022 |
| | | | | EP | 3964849 | A1 | 09 March 2022 |
| | | | | EP | 3964849 | B1 | 01 May 2024 |
| | | | | US | 12095056 | B2 | 17 September 2024 |
| | | | | US | 2022-0077514 | A1 | 10 March 2022 |
| KR | 10-2021-0059566 | A | 25 May 2021 | KR | 10-2362208 | B1 | 10 February 2022 |
| KR | 10-2023-0088014 | A | 19 June 2023 | None | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240041265